# EUROPEAN PATENT APPLICATION

(11) **EP 4 797 297 A1**
(43) Date of publication of application: **26.08.2026**
(21) Application number: 25224032.0
(22) Date of filing: 16.12.2025
(51) Int. Cl.: H01F 38/14, H01F 27/28, H01F 27/29, H01F 27/36, H05K 1/18

(54) **WIRELESS TRANSMISSION MODULE**

(30) Priority: 24.02.2025 CN 202510202309
(71) Applicant: TDK Corporation, Tokyo 103-6128 (JP)
(72) Inventor: CHEN, Mao-Chun, 326 Taoyuan City (TW); YU, Tai-Hsien, 326 Taoyuan City (TW); LEE, Kuo-Jui, 326 Taoyuan City (TW); LI, Wei-Chun, 326 Taoyuan City (TW)
(74) Representative: Epping - Hermann - Fischer

(57) **Abstract**

A wireless transmission module for transmitting energy or signals includes a coil assembly and a first base. The coil assembly has a winding axis. The first base corresponds to the coil assembly. The coil assembly and the first base are arranged along the winding axis. The wireless transmission module further includes a second base. The coil assembly and the first base are disposed on a first side plate of the second base. A plurality of electronic components are disposed on a second side plate of the second base.

## Description

### CROSS REFERENCE TO RELATED APPLICATIONS

This application claims the benefit of China Patent Application No. 202510202309.7, filed on February 24, 2025, the entirety of which is incorporated by reference herein.

### TECHNICAL FIELD

The present disclosure relates to a wireless transmission module, and more particularly it relates to a wireless transmission module applied to wireless communication or wireless charging.

### BACKBGOUND

As technology has progressed, many kinds of electronic devices such as tablet computers and smartphones have begun to include the functionality of wireless charging. A user can place the electronic device on a wireless charging transmitting terminal, so that the wireless charging receiving terminal in the electronic device generates current by electromagnetic induction or electromagnetic resonance to charge the battery. Due to the convenience of wireless charging, electronic devices equipped with wireless charging modules have gradually become popular.

In general, a wireless charging device includes a magnetic conductive plate to support a coil. When the coil is provided with electricity to operate in a wireless charging mode or a wireless communication mode, the magnetic conductive plate can concentrate the magnetic lines of force emitted from the coil for better performance. However, the structure of existing wireless charging (or communication) modules and the winding configuration of their coils cannot meet various requirements for wireless devices, such as better charging performance, communication performance and less thickness.

Therefore, how to design a wireless transmission module capable of fulfilling various needs of the user is a topic nowadays that needs to be discussed and solved.

### BRIEF SUMMARY

Accordingly, one objective of the present disclosure is to provide a wireless transmission module to solve the above problems.

According to some embodiments of the disclosure, a wireless transmission module for transmitting energy or signals includes a coil assembly and a first base. The coil assembly has a winding axis. The first base corresponds to the coil assembly. The coil assembly and the first base are arranged along the winding axis.

According to some embodiments, the wireless transmission module further includes a second base which is configured to carry the coil assembly and the first base. The second base has a first side plate and a second side plate. The first side plate is opposite to the second side plate. The coil assembly and the first base are disposed on the first side plate. The wireless transmission module further includes a plurality of electronic components which are disposed on the second side plate. The electronic components include resistors, capacitors, inductors, integrated circuit chips or a combination thereof. The electronic components do not include any coil for wireless transmission.

According to some embodiments, the second base further has a first electrical contact and a second electrical contact, which are disposed on the first side plate. The coil assembly includes a winding body, a first leading wire and a second leading wire. The first leading wire and the second leading wire extend from the winding body and are configured to be connected to the first electrical contact and the second electrical contact respectively. The thickness of the coil assembly along the winding axis is less than 1 mm. The width of the first leading wire or the second leading wire is greater than 1 mm.

According to some embodiments, the second base further includes a plurality of traces, which are partially disposed between the first side plate and the second side plate. The second base further includes a central layer plate, which is disposed between the first side plate and the second side plate. A portion of the traces is located in the central layer plate. At least one of the traces is configured to be electrically connected to two of the electronic components. When viewed along the winding axis, a portion of the traces overlaps a portion of the coil assembly.

According to some embodiments, the second base further includes two power input contacts, which are disposed on the second side plate. The two power input contacts are configured to be electrically connected to one of the electronic components via two of the traces. The wireless transmission module further includes a first adhesive element, a second adhesive element and a protective element. The coil assembly is affixed to the first base by the first adhesive element and the protective element. The first base is affixed to the first side plate by the second adhesive element. The protective element corresponds to the second adhesive element. The first base is disposed between the second adhesive element and the protective element. When viewed along the winding axis, the protective element completely shields the first base.

According to some embodiments, the second base further includes a plurality of detection contacts which are disposed on the second side plate. The detection contacts are configured to be electrically connected to at least one of the electronic components. The second base further includes a first via and a second via. The first via and the second via penetrate the central layer plate. The detection contacts include a first detection contact and a second detection contact. The first via is configured to be connected to the first electrical contact and the first detection contact. The second via is configured to be connected to the second electrical contact and the second detection contact.

According to some embodiments, the first base has a first opening corresponding to the first electrical contact and the second electrical contact. When viewed along the winding axis, the first electrical contact and the second electrical contact are exposed from the first opening. When viewed along the winding axis, a portion of the first leading wire and a portion of the second leading wire overlap the first opening. The wireless transmission module further includes a first adhesive element and a second adhesive element. The first adhesive element has a ring-shaped structure corresponding to the winding body. The size of the first adhesive element is different from the size of the winding body. The first adhesive element is configured to affix the coil assembly to the first base.

According to some embodiments, the shape of the second adhesive element corresponds to the shape of the first base. The second adhesive element is configured to affix the first base to the second base. When viewed along the winding axis, the second base has a rectangular structure. The second base defines a first axis and a second axis. The first axis is perpendicular to the second axis. The winding axis is perpendicular to the first axis and the second axis.

According to some embodiments, when viewed along the first axis, a portion of the first leading wire and a portion of the second leading wire overlap the first base. When viewed along the second axis, a portion of the first leading wire and a portion of the second leading wire overlap the first base. A portion of the first leading wire and a portion the second leading wire are located in the first opening.

According to some embodiments, when viewed along the winding axis, the rectangular structure has a first side. The first opening is located on the first side. When viewed along the winding axis, the first base has a U-shaped structure. The second adhesive element has a second opening corresponding to the first opening. When viewed along the winding axis, the second adhesive element has a U-shaped structure. When viewed along the winding axis, the first opening does not overlap the winding body. The first leading wire and the second leading wire extend outward from the winding body to the first electrical contact and the second electrical contact.

According to some embodiments, along the second axis, the second base has a first width. Along the second axis, the first base has a second width. The second width is more than 90% of the first width. The winding body has a diameter. The diameter is more than 70% of the second width.

According to some embodiments, when viewed along the winding axis, the rectangular structure has a central region. The first opening is located in the central region. When viewed along the winding axis, the first base has a frame-shaped structure. The second adhesive element has a second opening corresponding to the first opening. When viewed along the winding axis, the second adhesive element has a frame-shaped structure. When viewed along the winding axis, the winding body surrounds the first opening.

According to some embodiments, when viewed along the winding axis, the winding body surrounds the first electrical contact and the second electrical contact. When viewed along the winding axis, the winding body surrounds the first leading wire and the second leading wire. The first leading wire and the second leading wire extend inward from the winding body to the first electrical contact and the second electrical contact.

According to some embodiments, the second base further includes a first via and a second via. The first via is configured to connect to the first electrical contact. The second via is configured to connect to the second electrical contact. When viewed along the winding axis, the winding body surrounds the first via and the second via. The coil assembly is electrically connected to at least one of the electronic components through the first via and the second via.

According to some embodiments, along the second axis, the second base has a first width. Along the second axis, the first base has a second width. The second width is more than 90% of the first width. The winding body has a diameter. The diameter is more than 80% of the second width.

The present disclosure provides a wireless transmission module, which includes a coil assembly, a first base, and a second base. The coil assembly and the first base are disposed on a first side plate of the second base. A plurality of electronic components are disposed on a second side plate of the second base. Since all electronic components are disposed on the second side plate, the process time of the surface mounting process can be reduced by half, and it is also convenient for the operator to install the coil assembly on the first side plate, thereby increasing the convenience of assembly.

In addition, the second base can be a printed circuit board having a plurality of traces disposed therein for electrical connection, and the first base can be a magnetic conductive body. The magnetic conductive body may be, such as made of ferrite, for example. Since the first base is disposed between the coil assembly and the traces, the traces and the coil assembly do not interfere with each other and can operate normally. That is, the first base has the function of protecting and isolating signal interference.

### BRIEF DESCRIPTION OF THE DRAWINGS

Aspects of the present disclosure are best understood from the following detailed description when read with the accompanying figures. It is noted that, in accordance with the standard practice in the industry, various features are not drawn to scale. In fact, the dimensions of the various features may be arbitrarily increased or reduced for clarity of discussion.
FIG. 1 is a stereoscopic diagram of a wireless transmission module 10 according to an embodiment of the present disclosure;
FIG. 2 is a stereoscopic diagram of the wireless transmission module 10 in another view according to an embodiment of the present disclosure;
FIG. 3 is a three-dimensional view of a wireless transmission module 100 according to an embodiment of the present disclosure;
FIG. 4 is a bottom view of the wireless transmission module 100 according to an embodiment of the present disclosure;
FIG. 5 is a cross-sectional view of the wireless transmission module 100 along line A-A in FIG. 3 according to an embodiment of the present disclosure;
FIG. 6 is a three-dimensional view of a wireless transmission module 100A according to an embodiment of the present disclosure;
FIG. 7 is an exploded diagram of the wireless transmission module 100A in another view according to an embodiment of the present disclosure;
FIG. 8 is a front view of the wireless transmission module 100A according to an embodiment of the present disclosure;
FIG. 9 is a three-dimensional diagram of a wireless transmission module 100B according to an embodiment of the present disclosure;
FIG. 10 is an exploded diagram of the wireless transmission module 100B according to an embodiment of the present disclosure; and
FIG. 11 is a top view of the wireless transmission module 100B according to an embodiment of the present disclosure.

### DETAILED DESCRIPTION

The following disclosure provides many different embodiments, or examples, for implementing different features of the provided subject matter. Specific examples of components and arrangements are described below to simplify the present disclosure. These are, of course, merely examples and are not intended to be limiting. For example, the formation of a first feature over or on a second feature in the description that follows may include embodiments in which the first and second features are in direct contact, and may also include embodiments in which additional features may be disposed between the first and second features, such that the first and second features may not be in direct contact.

In addition, the present disclosure may repeat reference numerals and/or letters in the various examples. This repetition is for the purpose of simplicity and clarity and does not in itself dictate a relationship between the various embodiments and/or configurations discussed. Moreover, the formation of a feature on, connected to, and/or coupled to another feature in the present disclosure that follows may include embodiments in which the features are in direct contact, and may also include embodiments in which additional features may be disposed interposing the features, such that the features may not be in direct contact. In addition, spatially relative terms, for example, "vertical," "above," "over," "below,", "bottom," etc. as well as derivatives thereof (e.g., "downwardly," "upwardly," etc.) are used in the present disclosure for ease of description of one feature's relationship to another feature. The spatially relative terms are intended to cover different orientations of the device, including the features.

Unless defined otherwise, all technical and scientific terms used herein have the same meaning as commonly understood by one of ordinary skill in the art to which this disclosure belongs. It should be appreciated that each term, which is defined in a commonly used dictionary, should be interpreted as having a meaning conforming to the relative skills and the background or the context of the present disclosure, and should not be interpreted in an idealized or overly formal manner unless defined otherwise.

Use of ordinal terms such as "first", "second", etc., in the claims to modify a claim element does not by itself connote any priority, precedence, or order of one claim element over another or the temporal order in which acts of a method are performed, but are used merely as labels to distinguish one claim element having a certain name from another element having the same name (but for use of the ordinal term) to distinguish the claim elements.

In addition, in some embodiments of the present disclosure, terms concerning attachments, coupling and the like, such as "connected" and "interconnected", refer to a relationship wherein structures are secured or attached to one another either directly or indirectly through intervening structures, as well as both movable or rigid attachments or relationships, unless expressly described otherwise.

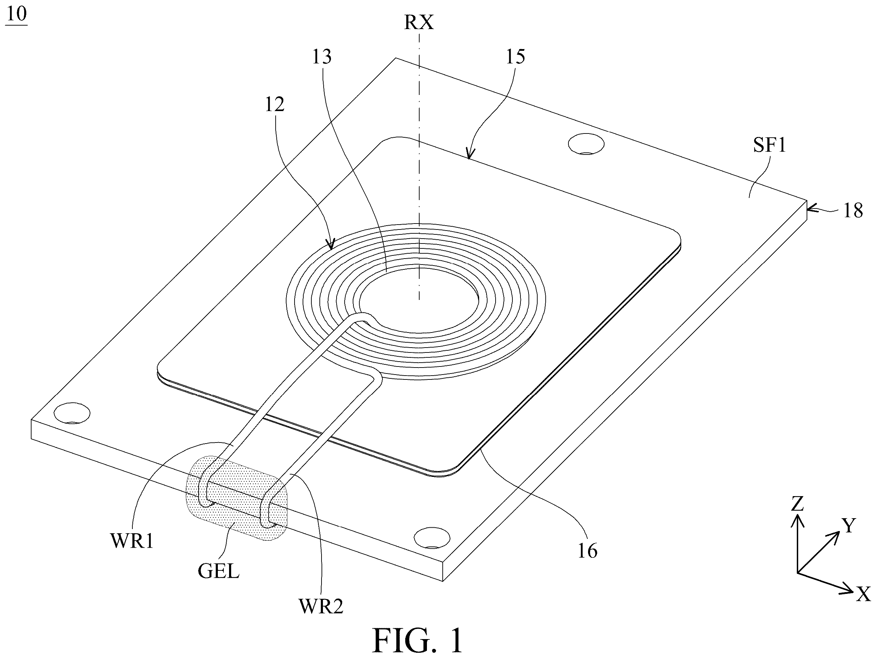

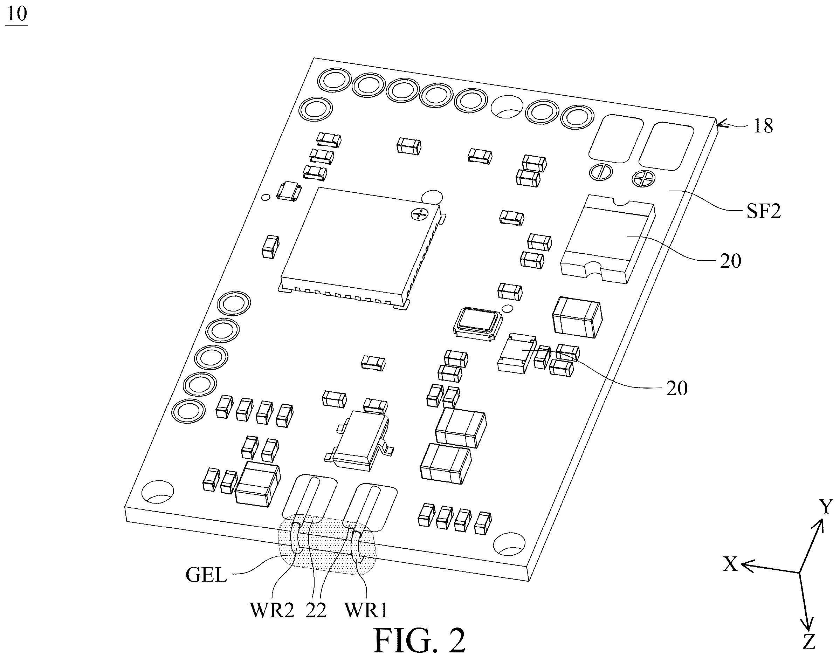

Please refer to FIG. 1 and FIG. 2, FIG. 1 is a stereoscopic diagram of a wireless transmission module 10 according to an embodiment of the present disclosure, and FIG. 2 is a stereoscopic diagram of the wireless transmission module 10 in another view according to an embodiment of the present disclosure. As shown in FIG. 1, the wireless transmission module 10 is a wireless transmission module that can be used to transmit energy or signals. In this embodiment, the wireless transmission module 10 may include a coil assembly 12, a first adhesive element 13, a magnetically permeable base 15, a second adhesive element 16, and a base plate 18.

In this embodiment, the coil assembly 12, the first adhesive element 13, the magnetically permeable base 15, the second adhesive element 16, and the base plate 18 are arranged and stacked along the extending direction of a winding axis RX of the coil assembly 12 in sequence.

Specifically, the coil assembly 12 is fixedly disposed on the magnetically permeable base 15 by the first adhesive element 13, and the magnetically permeable base 15 is fixedly disposed on the base plate 18 by the second adhesive element 16. In this embodiment, the coil assembly 12 may be a winding coil, the magnetically permeable base 15 may be a magnetic body, the first adhesive element 13 and the second adhesive element 16 may be double-sided adhesive tape or single-sided adhesive tape, and the base plate 18 may be a printed circuit board, but they are not limited thereto.

As shown in FIG. 1 and FIG. 2, the base plate 18 has a first surface SF1 and a second surface SF2, and the coil assembly 12 and the magnetically permeable base 15 are disposed on the first surface SF1. Furthermore, the wireless transmission module 10 may further include a plurality of electronic components 20 and two electrical contacts 22 which are disposed on the second surface SF2. The electronic component 20 is, for example, a capacitor, a resistor, a transistor, an integrated circuit chip, and so on.

As shown in FIG. 1 and FIG. 2, the coil assembly 12 has a first leading wire WR1 and a second leading wire WR2, which are respectively connected to the two electrical contacts 22. It is worth noting that the first leading wire WR1 and the second leading wire WR2 are extended from the first surface SF1 to the second surface SF2, and a glue GEL can be provided at the junction of the first surface SF1 and the second surface SF2 to affix the first leading wire WR1 and the second leading wire WR2.

Based on such a configuration, since all the electronic components 20 are disposed on the second surface SF2, it is not necessary to perform the surface mount technology (SMT) process on both surfaces, thereby reducing the process time of the surface mount technology by half, and it is also convenient for the operator to install the coil assembly 12 on the first surface SF1, thereby increasing the convenience of assembly.

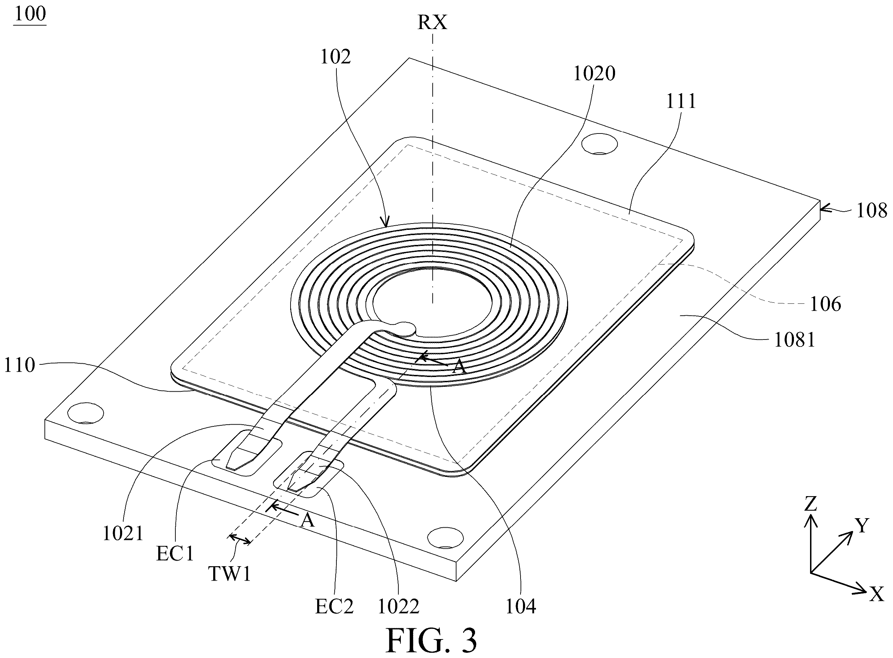

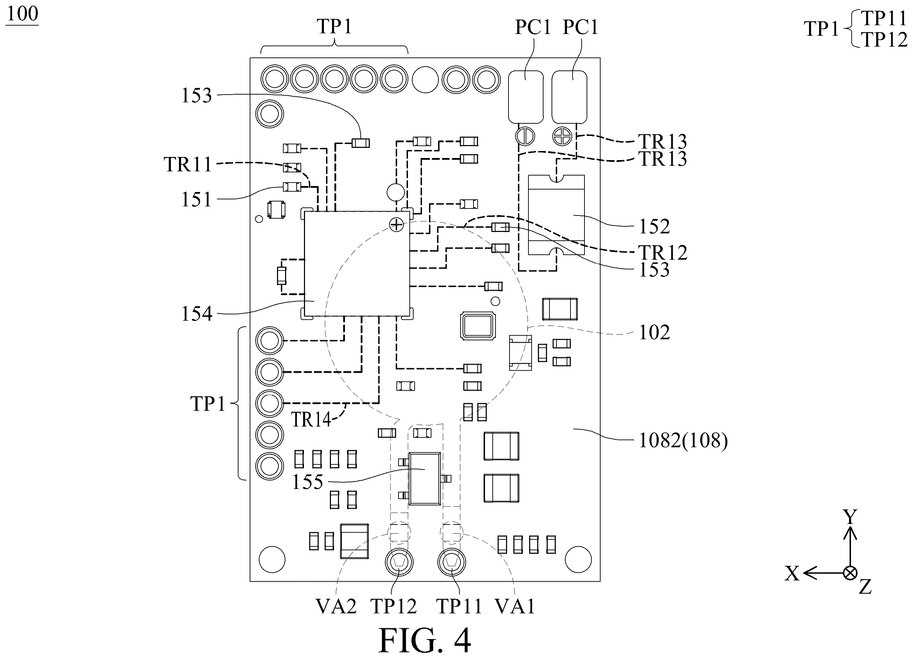

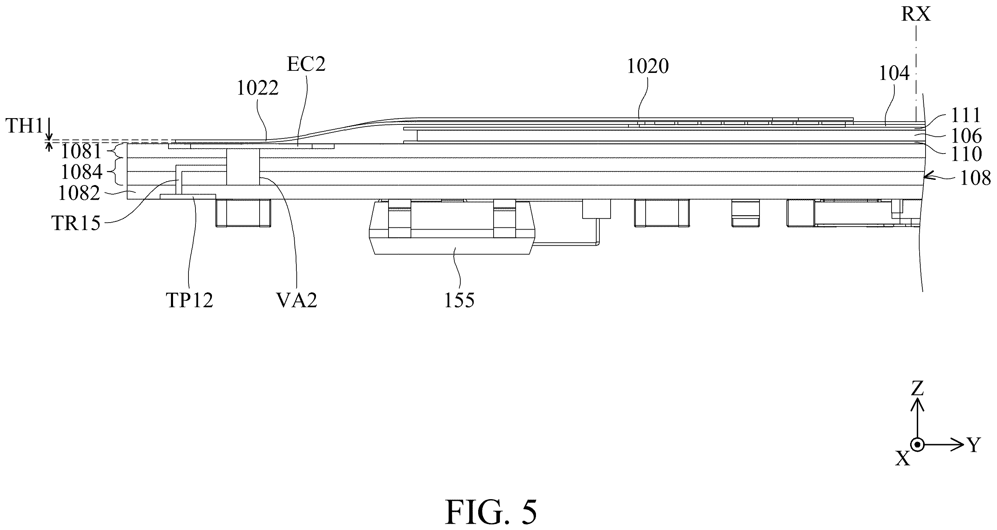

Next, please refer to FIG. 3 to FIG. 5. FIG. 3 is a three-dimensional view of a wireless transmission module 100 according to an embodiment of the present disclosure, FIG. 4 is a bottom view of the wireless transmission module 100 according to an embodiment of the present disclosure, and FIG. 5 is a cross-sectional view of the wireless transmission module 100 along line A-A in FIG. 3 according to an embodiment of the present disclosure. In this embodiment, the wireless transmission module 100 may include a coil assembly 102 and a first base 106. The coil assembly 102 defines a winding axis RX, the first base 106 corresponds to the coil assembly 102, and the coil assembly 102 and the first base 106 are arranged along the winding axis RX.

Furthermore, the wireless transmission module 100 may further include a second base 108 which is configured to carry the coil assembly 102 and the first base 106. The second base 108 has a first side plate 1081 and a second side plate 1082, and the first side plate 1081 is opposite to the second side plate 1082. For example, the first side plate 1081 and the second side plate 1082 are located on opposite sides of the second base 108.

The coil assembly 102 and the first base 106 are disposed on the first side plate 1081. Specifically, the wireless transmission module 100 may further include a first adhesive element 104, a second adhesive element 110, and a protective element 111. The coil assembly 102 is affixed to the first base 106 by the first adhesive element 104 and the protective element 111, and the first base 106 is affixed to the first side plate 1081 of the second base 108 by the second adhesive element 110.

In this embodiment, the first base 106 is configured to change the electromagnetic field distribution near the coil assembly 102. The first base 106 may be a magnetic conductive body, such as ferrite, but it is not limited thereto. For example, in other embodiments, the first base 106 may also include a nanocrystalline material. The first base 106 may have a magnetic permeability corresponding to the coil assembly 102, so that the electromagnetic waves of the coil assembly 102 are more concentrated.

The first adhesive element 104, the second adhesive element 110, and the protective element 111 may be double-sided adhesive or single-sided adhesive for adhering to one or two adjacent elements. In some embodiments, the first adhesive element 104, the second adhesive element 110, or the protective element 111 may be made of polyethylene terephthalate (PET), but they are not limited thereto. For example, the first adhesive element 104, the second adhesive element 110 and the protective element 111 may also be made of polypropylene (PP).

As shown in FIG. 5, the protective element 111 corresponds to the second adhesive element 110. For example, the protective element 111 and the second adhesive element 110 may have the same size, and the first base 106 is disposed between the second adhesive element 110 and the protective element 111, so that the second adhesive element 110 and the protective element 111 cooperatively cover and protect the first base 106.

For example, as shown in FIG. 3, when viewed along the winding axis RX, the protective element 111 completely shields the first base 106, but it is not limited thereto. In other embodiments, the protective element 111 may also be omitted.

In this embodiment, the coil assembly 102 can serve as a charging coil to be wireless charged by an external charging device. For example, the coil assembly 102 can operate as a resonant charging coil based on the standard of the Alliance for Wireless Power (A4WP), but it is not limited thereto.

In addition, the coil assembly 102 can operate as an inductive charging coil based on the standard of Wireless Power Consortium (WPC), such as the Qi standard. Therefore, the coil assembly 102 can respond to different forms of charging so as to enlarge the range of applications in this embodiment. For example, in the case of a close distance (for example, 1 cm or less), the inductive type operation is used; and at a long distance, a resonance type operation is used.

In this embodiment, the coil assembly 102 can also be used as a communication coil, for example, operating in Near Field Communication (NFC) mode to communicate with external electronic devices.

Similar to the aforementioned embodiment, the wireless transmission module 100 further includes a plurality of electronic components disposed on the second side plate 1082. These electronic components may be resistors 151, inductors 152, capacitors 153, integrated circuit chips 154, transistors 155 or a combination thereof, but they are not limited thereto.

It is also worth noting that these electronic components do not include any coil for wireless transmission. That is, the wireless transmission module 100 has only one single coil assembly 102 disposed on the first side plate 1081, and no coil for wireless transmission is disposed on the second side plate 1082.

As shown in FIG. 3 and FIG. 5, the second base 108 further includes a first electrical contact EC1 and a second electrical contact EC2 which are disposed on the first side plate 1081 and configured to be electrically connected to the coil assembly 102.

As shown in FIG. 3, the coil assembly 102 has a winding body 1020, a first leading wire 1021, and a second leading wire 1022. The first leading wire 1021 and the second leading wire 1022 extend from the winding body 1020 and are configured to be connected to the first electrical contact EC1 and the second electrical contact EC2, respectively.

It is worth noting that the coil assembly 102 can be a pattern coil having a thin structure. Specifically, as shown in FIG. 5, the thickness TH1 of the winding of the coil assembly 102 along the winding axis RX (the Z-axis) is less than 1 mm, for example, 0.38 mm, but it is not limited thereto.

Furthermore, as shown in FIG. 3, a width TW1 of the first leading wire 1021 or the second leading wire 1022 is greater than 1 mm, for example, they may be 1.5 mm or 2 mm, but they are not limited thereto. Based on such a configuration, the overall thickness of the wireless transmission module 100 can be further reduced, thereby achieving the purpose of miniaturization.

Next, in this embodiment, as shown in FIG. 4, the second base 108 can be a printed circuit board, which can include a plurality of traces, which are partially disposed between the first side plate 1081 and the second side plate 1082.

In this embodiment, the second base 108 has a multi-layer structure. For example, as shown in FIG. 5, the first side plate 1081 is the first layer, the second side plate 1082 is, for example, the second layer, and the second base 108 further includes a central layer plate 1084, which is disposed between the first side plate 1081 and the second side plate 1082.

The central layer plate 1084 is, for example, the third layer and the fourth layer, and a portion of these traces is located in the central layer plate 1084. These traces can be distributed in the third layer and the fourth layer or two other layers.

These traces are configured to electrically connect to these electronic components. For example, as shown in FIG. 4, one of the traces TR11 is connected to the integrated circuit chip 154 and the resistor 151, and the other trace TR12 is connected to the integrated circuit chip 154 and the capacitor 153.

It is worth noting that, as shown in FIG. 4, when viewed along the winding axis RX (the Z-axis), a portion of these traces (such as the trace TR12) overlaps a portion of the coil assembly 102, and because the first base 106 is disposed between the coil assembly 102 and these traces, these traces and the coil assembly 102 do not interfere with each other and can operate normally. That is, the first base 106 has the functions of protection and isolation.

Please continue to refer to FIG. 4. In this embodiment, the second base 108 further includes two power input contacts PC1, which are disposed on the second side plate 1082. The two power input contacts PC1 are configured to be electrically connected to one of the electronic components via two of the traces. For example, the two power input contacts PC1 are electrically connected to the inductor 152 via two traces TR13.

In addition, the second base 108 may further include a plurality of detection contacts TP1, which are disposed on the second side plate 1082. These detection contacts TP1 are configured to be electrically connected to at least one of the electronic components. The user can detect whether these electronic components operate normally through the detection contacts TP1.

For example, the detection contacts TP1 can be electrically connected to integrated circuit chip 154 via the traces TR14, so that the user can detect whether integrated circuit chip 154 operates normally through detection contacts TP1.

Furthermore, as shown in FIG. 4 and FIG. 5, the second base 108 further includes a first via VA1 and a second via VA2, and first via VA1 and second via VA2 penetrate the central layer plate 1084.

These detection contacts TP1 can include a first detection contact TP11 and a second detection contact TP12, the first via VA1 is configured to connect to the first electrical contact EC1 and the first detection contact TP11, and the second via VA2 is configured to connect to the second electrical contact EC2 and the second detection contact TP12.

For example, as shown in FIG. 5, the second via VA2 is connected to the second electrical contact EC2, and the second via VA2 is further connected to the second detection contact TP12 via the trace TR15. Therefore, the user can detect the coil assembly 102 via the first detection contact TP11 and the second detection contact TP12.

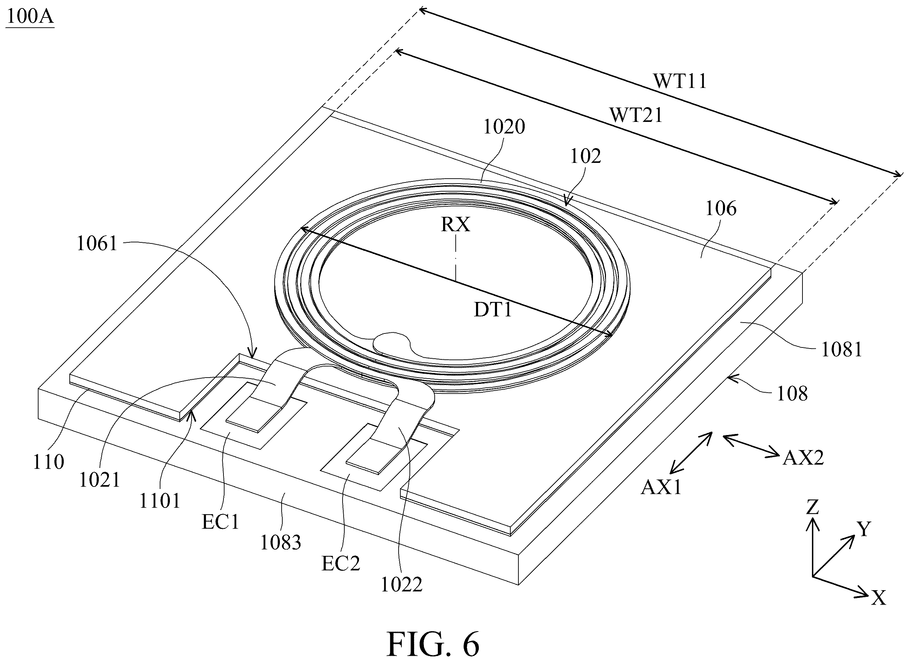

Next, please refer to FIG. 6 to FIG. 8. FIG. 6 is a three-dimensional view of a wireless transmission module 100A according to an embodiment of the present disclosure,

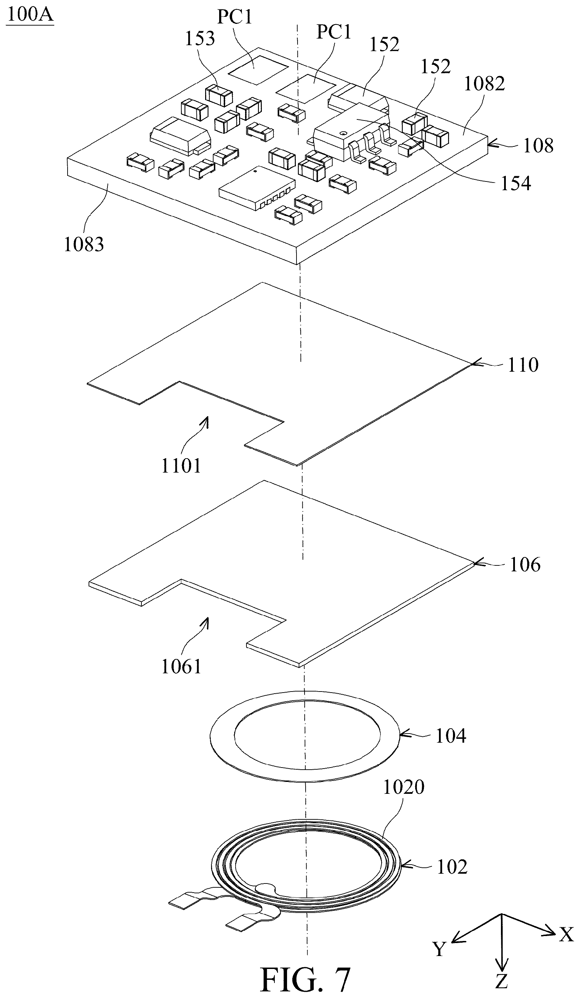

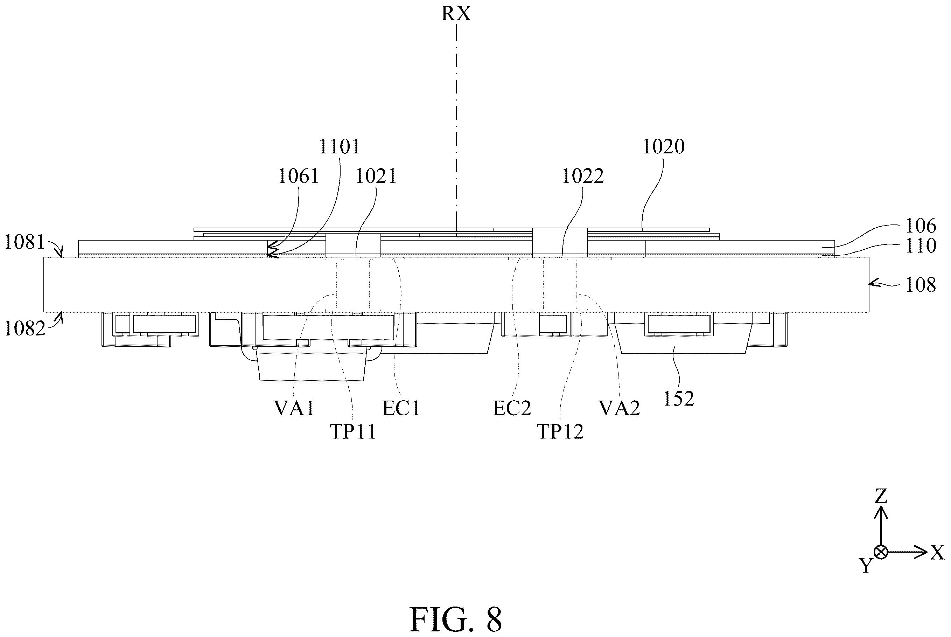

FIG. 7 is an exploded diagram of the wireless transmission module 100A in another view according to an embodiment of the present disclosure, and FIG. 8 is a front view of the wireless transmission module 100A according to an embodiment of the present disclosure.

Similar to the aforementioned embodiment, the wireless transmission module 100A of this embodiment includes a coil assembly 102, a first adhesive element 104, a first base 106, a second adhesive element 110, and a second base 108, which are arranged and stacked together along the extending direction of the winding axis RX in sequence.

Similarly, the coil assembly 102 is affixed to the first base 106 by the first adhesive element 104, the first base 106 is affixed to the first side plate 1081 of the second base 108 by the second adhesive element 110, and a plurality of electronic components (such as the inductor 152, the capacitor 153, the integrated circuit chip 154, and so on) are disposed on the second side plate 1082.

It is worth noting that in this embodiment, as shown in FIG. 6 and FIG. 7, the first base 106 has a first opening 1061 corresponding to the first electrical contact EC1 and the second electrical contact EC2.

When viewed along the winding axis RX, the first electrical contact EC1 and the second electrical contact EC2 are exposed from the first opening 1061, and when viewed along the winding axis RX, a portion of the first leading wire 1021 and a portion of the second leading wire 1022 overlap the first opening 1061.

In addition, as shown in FIG. 7, the first adhesive element 104 has a ring-shaped structure corresponding to the winding body 1020. That is, the winding body 1020 also has a ring-shaped structure. The size of the first adhesive element 104 is different from the size of the coil assembly 102. For example, the size of the first adhesive element 104 is slightly larger than or equal to the size of the coil assembly 102 (but they are not limited thereto) to affix the coil assembly 102 to the first base 106.

Similarly, the shape of the second adhesive element 110 corresponds to the shape of the first base 106, and the size of the second adhesive element 110 is substantially equal to the size of the first base 106 (within a tolerance range) so as to affix the first base 106 to the second base 108.

Furthermore, as shown in FIG. 6 and FIG. 7, when viewed along the winding axis RX, the second base 108 has a rectangular structure, and the second base 108 can define a first axis AX1 and a second axis AX2. The first axis AX1 is perpendicular to the second axis AX2.

As shown in FIG. 8, when viewed along the first axis AX1 (the Y-axis), a portion of the first leading wire 1021 and a portion of the second leading wire 1022 overlap the first base 106 and the second adhesive element 110.

Similarly, as shown in FIG. 6, when viewed along the second axis AX2, a portion of the first leading wire 1021 and a portion of the second leading wire 1022 overlap the first base 106. That is, a portion of the first leading wire 1021 and a portion of the second leading wire 1022 are located in the first opening 1061.

As shown in FIG. 6 and FIG. 7, when viewed along the winding axis RX, the rectangular structure of the second base 108 has a first side 1083, and the first opening 1061 is located on the first side 1083. When viewed along the winding axis RX, the first base 106 may have a U-shaped structure.

Similarly, the second adhesive element 110 has a second opening 1101 corresponding to the first opening 1061, and as shown in FIG. 6, the second opening 1101 is also located on the first side 1083. Similarly, when viewed along the winding axis RX, the second adhesive element 110 also has a U-shaped structure.

As shown in FIG. 6, when viewed along the winding axis RX, the first opening 1061 does not overlap the winding body 1020, and the first leading wire 1021 and the second leading wire 1022 extend outward from the winding body 1020 to the first electrical contact EC1 and the second electrical contact EC2.

Based on the configuration of the first opening 1061 and the second opening 1101, the first electrical contact EC1 and the second electrical contact EC2 can be exposed, thereby facilitating the first leading wire 1021 and the second leading wire 1022 to be welded to the first electrical contact EC1 and the second electrical contact EC2, respectively, thereby increasing the convenience of the process.

In addition, similar to the aforementioned embodiment, as shown in FIG. 8, the second base 108 also includes a first via VA1 and a second via VA2, the first via VA1 is configured to connect to the first electrical contact EC1 and the first detection contact TP11, and the second via VA2 is configured to connect to the second electrical contact EC2 and the second detection contact TP12, so that the user can detect the coil assembly 102 through the first detection contact TP11 and the second detection contact TP12.

In addition, in this embodiment, as shown in FIG. 6, along the second axis AX2, the second base 108 may have a first width WT11, and along the second axis AX2, the first base 106 may have a second width WT21. The second width WT21 is more than 90% of the first width WT11.

Similarly, as shown in FIG. 6, the winding body 1020 may have a diameter (a first diameter DT1), and the first diameter DT1 is greater than 70 percent of the second width WT21. Based on such a configuration, the winding body 1020 of the coil assembly 102 may be maximized, for example, may include more turns or a larger line width, so that the performance of the coil assembly 102 may be maximized within a limited size.

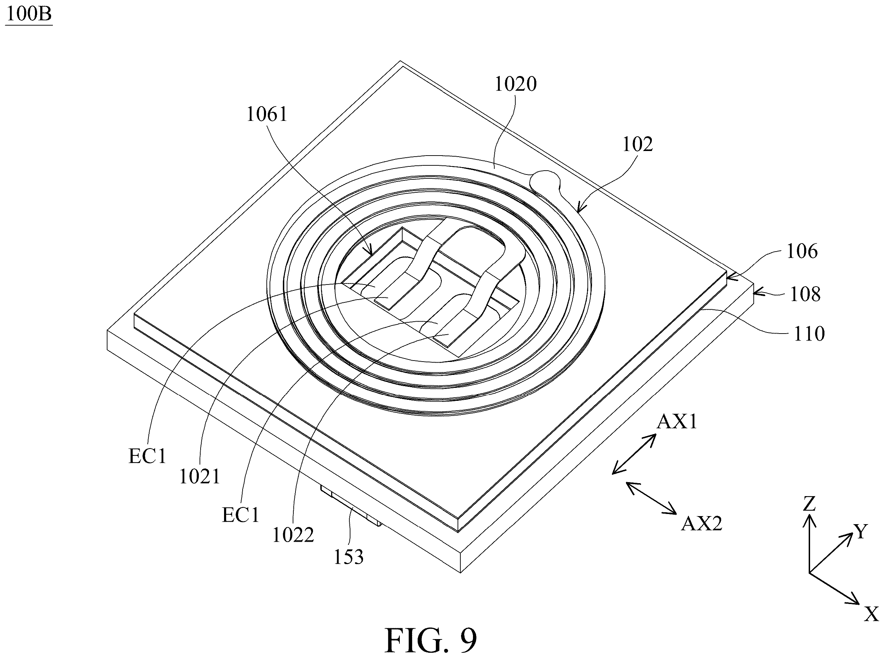

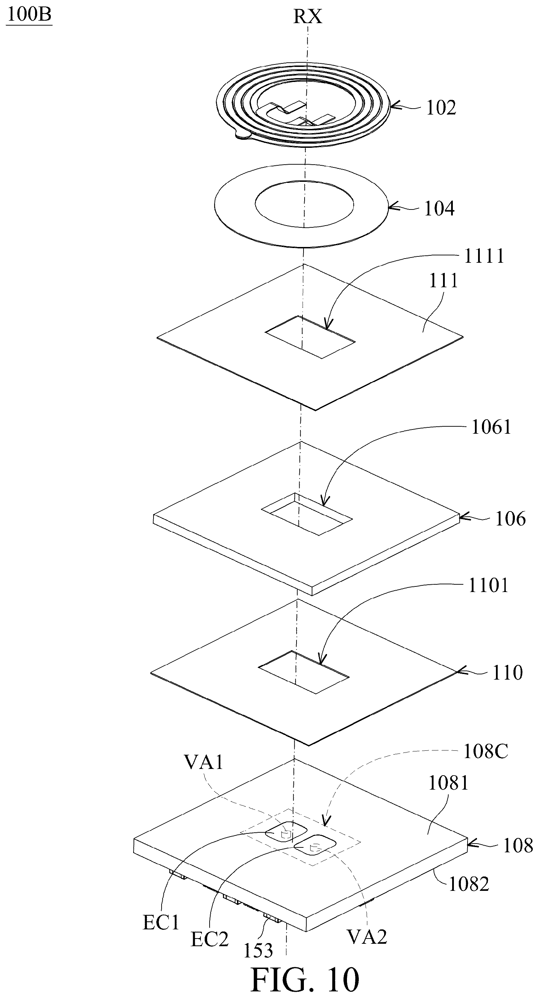

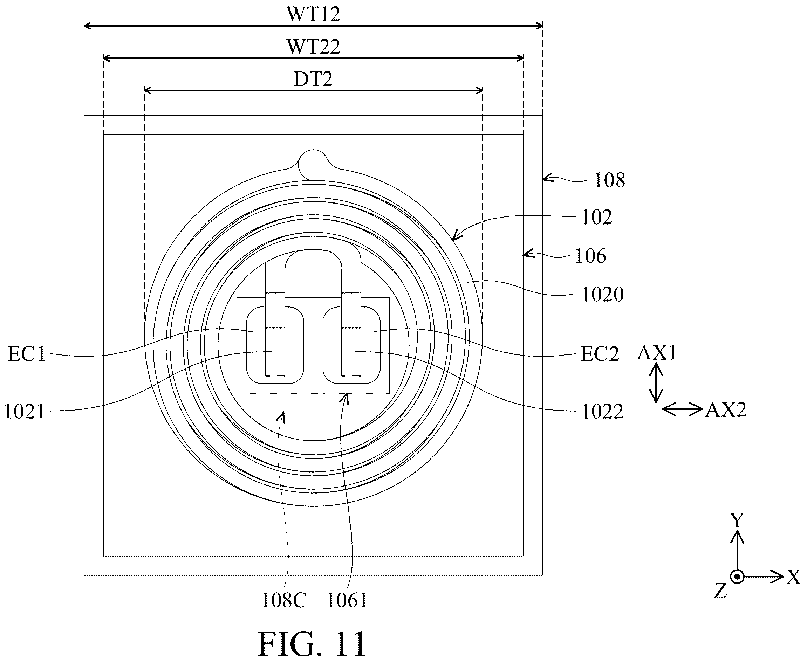

Next, please refer to FIG. 9 to FIG. 11. FIG. 9 is a three-dimensional diagram of a wireless transmission module 100B according to an embodiment of the present disclosure, FIG. 10 is an exploded diagram of the wireless transmission module 100B according to an embodiment of the present disclosure, and FIG. 11 is a top view of the wireless transmission module 100B according to an embodiment of the present disclosure.

Similar to the aforementioned embodiment, the wireless transmission module 100B of this embodiment includes a coil assembly 102, a first adhesive element 104, a protective element 111, a first base 106, a second adhesive element 110, and a second base 108, which are arranged along the extending direction of the winding axis RX in sequence.

Similarly, the coil assembly 102 is affixed to the first base 106 by the first adhesive element 104 and the protective element 111, the first base 106 is affixed to the first side plate 1081 of the second base 108 by the second adhesive element 110, and a plurality of electronic components are disposed on the second side plate 1082.

It is worth noting that in this embodiment, when viewed along the winding axis RX, the second base 108 has a rectangular structure, and when viewed along the winding axis RX, the rectangular structure may have a central region 108C, as shown in FIG. 10.

Similar to the aforementioned embodiment, the first base 106 of this embodiment also has a first opening 1061, and the first opening 1061 is located in the central region 108C. For example, as shown in FIG. 11, when viewed along the winding axis RX, the central region 108C also has a rectangular structure, and the first opening 1061 is located within the range of the central region 108C.

In this embodiment, the first opening 1061 is formed at the center of the first base 106, so that when viewed along the winding axis RX, the first base 106 has a frame-shaped structure.

Correspondingly, the second adhesive element 110 has a second opening 1101 corresponding to the first opening 1061, and when viewed along the winding axis RX, the second adhesive element 110 also has a frame-shaped structure.

The size of the second opening 1101 may be substantially equal to the size of the first opening 1061, but they are not limited thereto. For example, in other embodiments, the second opening 1101 may be larger than the first opening 1061.

Similarly, the protective element 111 has a third opening 1111 corresponding to the first opening 1061, and when viewed along the winding axis RX, the protective element 111 also has a frame-shaped structure.

The size of the third opening 1111 may be substantially equal to the size of the first opening 1061, but they are not limited thereto. For example, in other embodiments, the third opening 1111 may be larger than the first opening 1061.

As shown in FIG. 11, when viewed along the winding axis RX (the Z-axis), the winding body 1020 surrounds the first opening 1061, and when viewed along the winding axis RX, the winding body 1020 also surrounds the first electrical contact EC1 and the second electrical contact EC2. That is, the first electrical contact EC1 and the second electrical contact EC2 are located on the inner side of the winding body 1020.

Similar to the aforementioned embodiment, as shown in FIG. 10, the second base 108 further includes a first via VA1 and a second via VA2, which are respectively connected to the first electrical contact EC1 and the second electrical contact EC2, so that the coil assembly 102 is electrically connected to at least one electronic component (such as the integrated circuit chip 154) or a detection contacts via the first via VA1 and the second via VA2, but they are not limited thereto. These electronic components and the detection contacts are disposed on the second side plate 1082, and their configuration is similar to that of the wireless transmission module 100A, so they are not described in detail herein.

Furthermore, as shown in FIG. 11, when viewed along the winding axis RX, the winding body 1020 surrounds the first leading wire 1021 and the second leading wire 1022, and the first leading wire 1021 and the second leading wire 1022 extend inward from the winding body 1020 to the first electrical contact EC1 and the second electrical contact EC2.

Similarly, as shown in FIG. 11, along the second axis AX2, the second base 108 has a first width WT12, and along the second axis AX2, the first base 106 has a second width WT22. In this embodiment, the second width WT22 is more than 90 percent of the first width WT12.

In addition, the winding body 1020 has a diameter (a second diameter DT2), and the second diameter DT2 is more than 80 percent of the second width WT22. It is worth noting that the second diameter DT2 can be greater than the first diameter DT1 of the aforementioned embodiment. That is, the winding body 1020 of this embodiment can have a larger size.

Based on the above structural configuration, the coil assembly 102 of a larger size can be provided on the first base 106 of the same size so as to maximize the winding body 1020, for example, more turns or a larger line width can be provided, thereby further improving the performance of the coil assembly 102.

It should also be noted that in the present disclosure, the elements and configurations of some embodiments can be applied to other embodiments. For example, the first adhesive element 104 can have a ring-shaped structure in each embodiment, and the second side plate 1082 in each embodiment can be provided with the same or similar multiple electronic components.

In conclusion, the present disclosure provides a wireless transmission module 100, which includes a coil assembly 102, a first base 106, and a second base 108. The coil assembly 102 and the first base 106 are disposed on a first side plate 1081 of the second base 108, and a plurality of electronic components are disposed on a second side plate 1082 of the second base 108. Since all electronic components are disposed on the second side plate 1082, the process time of the surface mounting process can be reduced by half, and it is also convenient for the operator to install the coil assembly 102 on the first side plate 1081, thereby increasing the convenience of assembly.

In addition, the second base 108 can be a printed circuit board having a plurality of traces disposed therein for electrical connection, and the first base 106 can be a magnetic conductive body. The magnetic conductive body may be made of ferrite, for example. Since the first base 106 is disposed between the coil assembly 102 and the traces, the traces and the coil assembly 102 do not interfere with each other and can operate normally. That is, the first base 106 has the function of protecting and isolating signal interference.

Use of ordinal terms such as "first", "second", "third", etc., in the claims to modify a claim element does not by itself connote any priority, precedence, or order of one claim element over another or the temporal order in which acts of a method are performed, but are used merely as labels to distinguish one claim element having a certain name from another element having the same name (but for use of the ordinal term) to distinguish the claim elements.

Although the embodiments and their advantages have been described in detail, it should be understood that various changes, substitutions, and alterations can be made herein without departing from the spirit and scope of the embodiments as defined by the appended claims. Moreover, the scope of the present application is not intended to be limited to the particular embodiments of the process, machine, manufacture, composition of matter, means, methods, and steps described in the specification. As one of ordinary skill in the art will readily appreciate from the disclosure, processes, machines, manufacture, compositions of matter, means, methods, or steps, presently existing or later to be developed, that perform substantially the same function or achieve substantially the same result as the corresponding embodiments described herein can be utilized according to the disclosure. Accordingly, the appended claims are intended to include within their scope such processes, machines, manufacture, compositions of matter, means, methods, or steps. In addition, each claim constitutes a separate embodiment, and the combination of various claims and embodiments are within the scope of the disclosure.

## Claims

1. A wireless transmission module, comprising:
a coil assembly, having a winding axis; and
a first base, corresponding to the coil assembly;
wherein the coil assembly and the first base are arranged along the winding axis.

2. The wireless transmission module as claimed in claim 1, wherein
the wireless transmission module further includes a second base which is configured to carry the coil assembly and the first base;
the second base has a first side plate and a second side plate;
the first side plate is opposite to the second side plate;
the coil assembly and the first base are disposed on the first side plate;
the wireless transmission module further includes a plurality of electronic components which are disposed on the second side plate;
the electronic components include resistors, capacitors, inductors, integrated circuit chips or a combination thereof; and
the electronic components do not include any coil for wireless transmission.

3. The wireless transmission module as claimed in claim 2, wherein
the second base further has a first electrical contact and a second electrical contact, which are disposed on the first side plate;
the coil assembly includes a winding body, a first leading wire and a second leading wire;
the first leading wire and the second leading wire extend from the winding body and are configured to be connected to the first electrical contact and the second electrical contact respectively;
a thickness of the coil assembly along the winding axis is less than 1 mm; and
a width of the first leading wire or the second leading wire is greater than 1 mm.

4. The wireless transmission module as claimed in claim 3, wherein
the second base further includes a plurality of traces, which are partially disposed between the first side plate and the second side plate;
the second base further includes a central layer plate, which is disposed between the first side plate and the second side plate;
a portion of the traces is located in the central layer plate;
at least one of the traces is configured to be electrically connected to two of the electronic components; and
when viewed along the winding axis, a portion of the traces overlaps a portion of the coil assembly.

5. The wireless transmission module as claimed in claim 4, wherein
the second base further includes two power input contacts, which are disposed on the second side plate;
the two power input contacts are configured to be electrically connected to one of the electronic components via two of the traces;
the wireless transmission module further includes a first adhesive element, a second adhesive element and a protective element;
the coil assembly is affixed to the first base by the first adhesive element and the protective element;
the first base is affixed to the first side plate by the second adhesive element;
the protective element corresponds to the second adhesive element;
the first base is disposed between the second adhesive element and the protective element; and
when viewed along the winding axis, the protective element completely shields the first base.

6. The wireless transmission module as claimed in claim 5, wherein
the second base further includes a plurality of detection contacts which are disposed on the second side plate;
the detection contacts are configured to be electrically connected to at least one of the electronic components;
the second base further includes a first via and a second via;
the first via and the second via penetrate the central layer plate;
the detection contacts include a first detection contact and a second detection contact;
the first via is configured to be connected to the first electrical contact and the first detection contact; and
the second via is configured to be connected to the second electrical contact and the second detection contact.

7. The wireless transmission module as claimed in claim 3, wherein
the first base has a first opening corresponding to the first electrical contact and the second electrical contact;
when viewed along the winding axis, the first electrical contact and the second electrical contact are exposed from the first opening;
when viewed along the winding axis, a portion of the first leading wire and a portion of the second leading wire overlap the first opening;
the wireless transmission module further includes a first adhesive element and a second adhesive element;
the first adhesive element has a ring-shaped structure corresponding to the winding body;
a size of the first adhesive element is different from a size of the winding body; and
the first adhesive element is configured to affix the coil assembly to the first base.

8. The wireless transmission module as claimed in claim 7, wherein
a shape of the second adhesive element corresponds to a shape of the first base;
the second adhesive element is configured to affix the first base to the second base;
when viewed along the winding axis, the second base has a rectangular structure;
the second base defines a first axis and a second axis;
the first axis is perpendicular to the second axis; and
the winding axis is perpendicular to the first axis and the second axis.

9. The wireless transmission module as claimed in claim 8, wherein
when viewed along the first axis, a portion of the first leading wire and a portion of the second leading wire overlap the first base;
when viewed along the second axis, a portion of the first leading wire and a portion of the second leading wire overlap the first base; and
a portion of the first leading wire and a portion the second leading wire are located in the first opening.

10. The wireless transmission module as claimed in claim 9, wherein
when viewed along the winding axis, the rectangular structure has a first side;
the first opening is located on the first side;
when viewed along the winding axis, the first base has a u-shaped structure;
the second adhesive element has a second opening corresponding to the first opening;
when viewed along the winding axis, the second adhesive element has a u-shaped structure;
when viewed along the winding axis, the first opening does not overlap the winding body; and
the first leading wire and the second leading wire extend outward from the winding body to the first electrical contact and the second electrical contact.

11. The wireless transmission module as claimed in claim 10, wherein
along the second axis, the second base has a first width;
along the second axis, the first base has a second width;
the second width is more than 90% of the first width;
the winding body has a diameter; and
the diameter is more than 70% of the second width.

12. The wireless transmission module as claimed in claim 9, wherein
when viewed along the winding axis, the rectangular structure has a central region;
the first opening is located in the central region;
when viewed along the winding axis, the first base has a frame-shaped structure;
the second adhesive element has a second opening corresponding to the first opening;
when viewed along the winding axis, the second adhesive element has a frame-shaped structure; and
when viewed along the winding axis, the winding body surrounds the first opening.

13. The wireless transmission module as claimed in claim 12, wherein
when viewed along the winding axis, the winding body surrounds the first electrical contact and the second electrical contact;
when viewed along the winding axis, the winding body surrounds the first leading wire and the second leading wire; and
the first leading wire and the second leading wire extend inward from the winding body to the first electrical contact and the second electrical contact.

14. The wireless transmission module as claimed in claim 13, wherein
the second base further includes a first via and a second via;
the first via is configured to connect to the first electrical contact;
the second via is configured to connect to the second electrical contact;
when viewed along the winding axis, the winding body surrounds the first via and the second via; and
the coil assembly is electrically connected to at least one of the electronic components through the first via and the second via.

15. The wireless transmission module as claimed in claim 14, wherein
along the second axis, the second base has a first width;
along the second axis, the first base has a second width;
the second width is more than 90% of the first width;
the winding body has a diameter; and
the diameter is more than 80% of the second width.
